# FASCICULE DE BREVET EUROPEEN

(11) **EP 3 053 245 B1**
(45) Date de publication et mention de la délivrance du brevet: **11.07.2018**
(21) Numéro de dépôt: 14777593.6
(22) Date de dépôt: 30.09.2014
(51) Int. Cl.: H01M 10/00, H02J 7/34, H02J 7/00, H02J 3/00, H02M 3/00

(54) **PROCEDE D'OPTIMISATION D'UNE ARCHITECTURE D'ALIMENTATION ELECTRIQUE D'UNE CHARGE**
VERFAHREN ZUR OPTIMIERUNG DER ARCHITEKTUR EINER STROMQUELLE FÜR EINE LAST
METHOD FOR THE OPTIMISATION OF THE ELECTRIC SUPPLY ARCHITECTURE OF A LOAD

(30) Priorité: 30.09.2013 FR 1359451
(43) Date de publication de la demande: 10.08.2016
(73) Titulaire: AIRBUS (SAS), 31700 Blagnac (FR); ArianeGroup SAS, 75015 Paris (FR)
(72) Inventeur: FLEURY, Benoit, 78300 Poissy (FR); MASSIOT, Gregor, F-31000 Toulouse (FR); LANCELEVEE, Pierre-Bertrand, F-13100 Aix en Provence (FR); LABBE, Julien, F-92300 Levallois-Perret (FR)
(74) Mandataire: Gicquel, Olivier Yves Gérard
(86) Numéro de dépôt international: PCT/EP2014/070871
(87) Numéro de publication internationale: WO 2015/044439

(56) Documents cités:
- DE-A1-102010 024 235

## Description

### Domaine de l'invention

La présente invention se rapporte à un procédé d'optimisation d'une architecture d'alimentation électrique d'une charge. L'invention concerne plus particulièrement les alimentations électriques comportant plusieurs sources de stockage d'énergie également connus sous le terme « alimentation hybride ».

On entend par « alimentation hydride » une alimentation comprenant plusieurs sources de stockage d'énergie telles qu'une batterie associée à un pack de super-condensateurs ou encore une batterie associée à une pile à combustible.

L'invention trouve des applications dans de nombreux domaines et peut être utilisée dans les aéronefs, les satellites ou encore les véhicules spatiaux.

### Etat de la technique

Il existe plusieurs dispositifs connus utilisant une alimentation hybride alimentant une charge. Ces dispositifs sont notamment présents dans les bus électriques, les tramways ou les automobiles électriques ou hybrides. Ces dispositifs mettent en oeuvre des sources de stockage d'énergie complémentaires, tel qu'une batterie et un pack de super-condensateurs. L'art antérieur connait notamment le brevet N° FR 2 947 006 décrivant ce type de dispositif.

L'utilisation de plusieurs sources de stockage d'énergie permet d'utiliser une source de stockage d'énergie en source d'appoint lorsque la demande de la charge est importante. Cette source d'appoint est ultérieurement rechargée par la source principale lorsque les besoins de la charge sont moins importants que les capacités de production de la source principale.

Ces alimentations hybrides permettent ainsi de limiter la puissance nécessaire de la source de stockage d'énergie principale et de limiter la masse générale de l'alimentation. Cependant, pour une alimentation électrique donnée, il n'est pas toujours pertinent de vouloir utiliser une architecture multi-sources complexe plutôt que de conserver une solution simple avec une seule source d'alimentation, par exemple une batterie. Il existe donc un risque de développer une nouvelle architecture d'alimentation électrique basée sur une alimentation hydride qui pourrait se révéler plus lourde et moins performante que l'ancienne architecture.

### Exposé de l'invention

La présente invention entend résoudre ce problème en proposant un procédé permettant d'anticiper ce risque.

A cet effet, selon un premier aspect, l'invention concerne un procédé d'optimisation d'une architecture d'alimentation électrique d'une charge comportant les étapes suivantes : détermination d'un profil de mission dimensionnant en fonction de la puissance demandée par la charge au cours du temps, définition des sources de stockages d'énergie candidates à l'hybridation, association à chaque source de stockage d'énergie d'un modèle de comportement caractéristique, détermination des couples de sources de stockage d'énergie aptes à générer le profil de mission avec une masse minimale, et détermination, parmi les couples potentiels de sources de stockage d'énergie, du couple présentant la masse la plus faible.

L'invention permet ainsi d'identifier, avec un nombre restreint de variables, un couple de sources de stockage d'énergie présentant un optimum de performance. L'invention permet de limiter les utilisations de la deuxième source de stockage d'énergie par rapport à la première source de stockage d'énergie. En outre, un profil d'utilisation en puissance de la seconde source de stockage d'énergie peut prévoir des phases de recharge de la seconde source de stockage d'énergie par la première source de stockage d'énergie lorsque les besoins de la charge sont inférieurs à la capacité de production de la première source de stockage d'énergie.

Selon un mode de réalisation, chaque modèle de comportement caractéristique correspond à un diagramme de Ragone donnant l'énergie totale pouvant être fournie par la source de stockage d'énergie selon la puissance fournie rapportée par unité de masse de la source de stockage d'énergie. Ce mode de réalisation permet d'obtenir facilement les modèles de comportement caractéristiques car les diagrammes de Ragone sont généralement fournis par les constructeurs de sources de stockage d'énergie.

Selon un mode de réalisation, l'étape de détermination des couples de sources de stockage d'énergie aptes à générer le profil de mission avec une masse minimale comporte la sous-étape suivante, pour chaque couple de sources de stockage d'énergie candidates à l'hybridation, déterminer les points de fonctionnement du diagramme de Ragone des sources de stockage d'énergie aptes à générer le profil de mission et à minimiser la masse totale des deux sources de stockage d'énergie. Ce mode de réalisation permet de connaitre le point de fonctionnement de chaque source de stockage d'énergie et également la masse de chaque source de stockage d'énergie liée au point de fonctionnement du diagramme de Ragone.

Selon un mode de réalisation, le procédé comporte en outre une étape de comparaison de la masse du couple déterminé avec la masse d'une source d'énergie d'une architecture existante. Ce mode de réalisation permet d'anticiper le gain attendu en termes de masse et permet ainsi de décider de l'opportunité de modifier ou non l'architecture existante.

Selon un mode de réalisation, le procédé comporte les étapes suivantes : définition des convertisseurs de puissance candidats à l'hybridation, détermination des couples de sources de stockage d'énergie aptes à générer le profil de mission avec une masse minimale en fonction des convertisseurs de puissance disponibles, et détermination des convertisseurs de puissance en fonction du couple déterminé. Ce mode de réalisation permet d'intégrer une liste de convertisseurs de puissance disponibles dans l'optimisation de l'architecture d'alimentation électrique.

Selon un mode de réalisation, l'étape de définition des sources de stockages d'énergie candidates à l'hybridation propose des sources de stockages d'énergie de type batterie, super-condensateur ou pile à combustible. Ce mode de réalisation permet de présélectionner les sources de stockages d'énergie particulièrement adaptées à l'hybridation. Une batterie est préférentiellement utilisée en source principale et un pack de super-condensateurs est utilisé en source d'appoint.

Selon un mode de réalisation, le procédé comporte en outre une étape d'affichage des sources de stockage d'énergie du couple déterminé et des profils d'utilisation en puissance des sources de stockage d'énergie du couple déterminé.

Selon un deuxième aspect, l'invention concerne une architecture d'alimentation électrique d'une charge optimisée par un procédé selon l'invention.

### Brève description des dessins

On comprendra mieux l'invention à l'aide de la description, faite ci-après à titre purement explicatif, des modes de réalisation de l'invention, en référence aux Figures dans lesquelles :
- la Figure 1 est une représentation schématique d'une architecture d'alimentation électrique d'une charge ;
- la Figure 2 est un ordinogramme illustrant le procédé d'optimisation d'une architecture d'alimentation électrique selon l'invention ;
- la Figure 3 est une représentation schématique des entrées et des sorties du procédé de l'invention ; et
- la Figure 4 illustre une architecture d'alimentation électrique optimisée.

### Description détaillée des modes de réalisation de l'invention

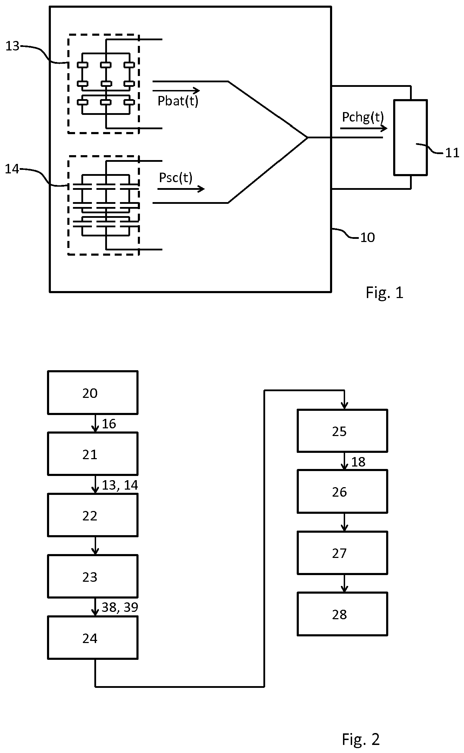

La Figure 1 illustre une architecture 10 d'alimentation électrique d'une charge 11. Les besoins de puissance Pchg(t) de la charge 11 sont complétés au cours du temps par deux sources de stockage d'énergie 13, 14. La première source de stockage d'énergie 13 correspond à un ensemble de batteries délivrant une puissance Pbat(t) et la seconde source de stockage d'énergie 14 correspond à un ensemble de super-condensateurs délivrant une puissance Psc(t). En variante, ces sources de stockage d'énergie peuvent varier sans changer l'invention. La charge 11 correspond à un actionneur quelconque tel qu'un servo-vérin.

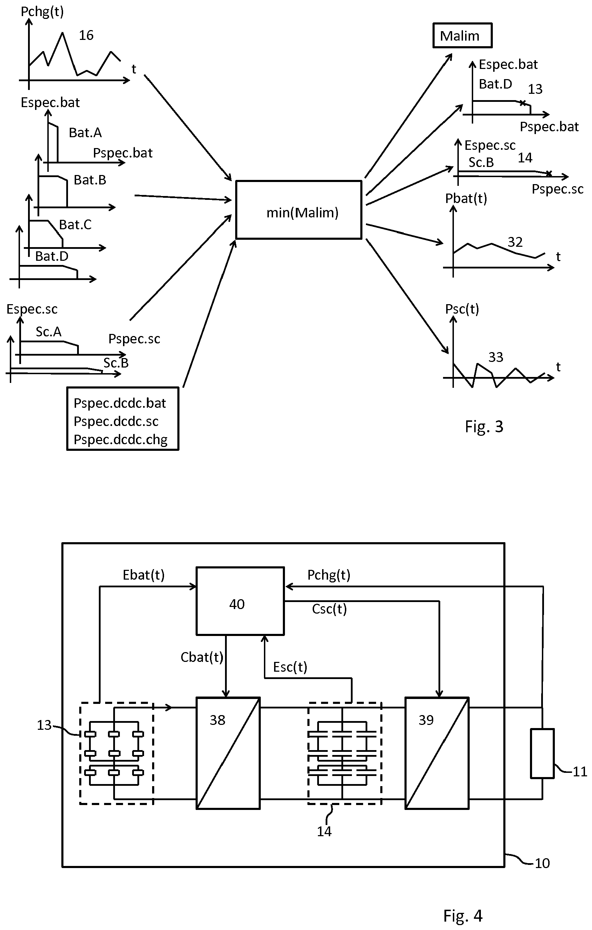

Cette architecture 10 est optimisée par le procédé d'optimisation décrit sur la Figure 2. Dans une première étape, le procédé détermine, lors d'une étape 20, un profil de mission 16 dimensionnant en fonction de la puissance Pchg(t) demandée par la charge 11 au cours du temps t. Un exemple de ce profil de mission 16 est représenté sur la Figure 3. En pratique, ce profil de mission 16 est déterminé par plusieurs séries de test des besoins Pchg(t) en puissance de la charge 11 au cours du temps t. Les instants les plus défavorables des mesures relevées sont concaténés et échantillonnés pour former le profil de mission 16. La discrétisation de l'échantillonnage permet de faire varier la précision du profil de mission 16.

Des sources de stockage d'énergie 13, 14 candidates à l'hybridation sont ensuite définies, lors d'une étape 21, et chaque source est associée, lors d'une étape 22, à un modèle de comportement caractéristique, par exemple un modèle de Ragone. Un modèle de Ragone donne l'énergie totale pouvant être fournie Espec.bat, Espec.sc par la source de stockage d'énergie 13, 14 selon la puissance fournie Pspec.bat, Pspec.sc rapportée par unité de masse de la source de stockage d'énergie 13, 14. La Figure 3 révèle quatre modèles de Ragone de batterie Bat.A, Bat.B, Bat.C et Bat.D ainsi que deux modèles de Ragone de packs de super-condensateurs Sc.A et Sc.B. Ces diagrammes de Ragone sont généralement fournis par le constructeur. Les sources de stockage d'énergie 13, 14 candidates à l'hybridation sont préférentiellement du type batterie, super-condensateur ou pile à combustible.

Parmi les sources de stockage d'énergie 13, 14 définies 21, le procédé détermine, lors d'une étape 24, des couples adaptés à l'hybridation et aptes à générer le profil de mission 16 avec une masse minimale. Pour chaque couple de sources de stockage d'énergie 13, 14 candidates à l'hybridation et pour chaque point de fonctionnement du diagramme de Ragone des sources de stockage d'énergie 13, 14, le procédé établi un problème de programmation qu'il résout afin de déterminer le profil d'utilisation des sources de stockage d'énergie 13, 14 qui minimise la masse de l'alimentation hybride.

Un couple 18 est déterminé, lors d'une étape 25, parmi les couples potentiels en recherchant le couple présentant la masse la plus faible. Dans l'exemple de la Figure 3, les sources de stockage d'énergie 13, 14 sont la batterie Bat.D et le pack de super-condensateurs Sc.b. Les points de fonctionnement sont représentés par des croix. Le procédé comporte également une étape de comparaison 26 de la masse Malim du couple 18 déterminé avec la masse d'une source d'énergie d'une architecture existante. Les points de fonctionnement permettent de définir des profils d'utilisation 32, 33 des sources de stockage d'énergie 13, 14 aptes à fournir le profil de mission. De faibles variations sont imposées au profil d'utilisation 32 de la première source de stockage d'énergie 13 alors que le profil d'utilisation 33 de la seconde source de stockage d'énergie 14 présente des variations plus importantes. Ainsi, la première source de stockage d'énergie 13 est une source d'énergie principale alors que la seconde source de stockage d'énergie 14 est une source d'énergie d'appoint permettant d'amortir les fortes variations des besoins de puissance Pchg(t) de la charge 11.

En plus de sélectionner les sources de stockage d'énergie 13, 14, le procédé de l'invention permet d'intégrer une liste de convertisseurs de puissance 38, 39 candidats à l'hybridation. Une étape 23 consiste à définir ces convertisseurs de puissance 38, 39 et les couples de sources de stockage d'énergie 13, 14 sont déterminés, lors d'une étape 24, en fonction de ces convertisseurs de puissance 38, 39. Dans l'exemple de la Figure 3, plusieurs puissances spécifiques des convertisseurs Pspec.dcdc.bat, Pspec.dcdc.sc et Pspec.dcdc.chg sont renseignés. Les convertisseurs de puissance 38, 39 sont déterminés, lors d'une étape 27, en fonction du couple 18 sélectionné.

Une étape 28 consiste à afficher les sources de stockage d'énergie 13, 14 du couple déterminé 18 et les profils d'utilisation 32, 33 en puissance des sources de stockage d'énergie 13, 14 du couple déterminé 18.

L'invention permet ainsi de définir une architecture 10 d'alimentation électrique optimisée d'une charge 11. La Figure 4 représente une architecture 10 d'alimentation électrique optimisée d'une charge 11. Un organe de calcul 40 commande deux convertisseurs 38, 39 aptes à définir une puissance Pbat(t) et Psc(t) délivrée par les éléments de stockage d'énergie 13, 14 par l'intermédiaire de deux moyens de commande Cbat(t) et Csc(t). Les moyens de commande Cbat(t) et Csc(t) sont ajustés au cours du temps t en fonction des besoins de puissance Pchg(t) de la charge 11 et des profils d'utilisation 32, 33 des sources de stockage d'énergie 13, 14.

## Revendications

1. Procédé d'optimisation d'une architecture (10) d'alimentation électrique d'une charge (11) qui comporte les étapes suivantes :
- détermination (20),par plusieurs séries de test, d'un profil de mission (16) dimensionnant en fonction de la puissance (Pchg(t)) demandée par la charge au cours du temps (t) ;
- définition (21) de sources de stockages d'énergie différentes (13, 14), candidates à l'hybridation, choisies parmi des sources de stockages d'énergie (13, 14) de type batterie, super-condensateur ou pile à combustible ;
- association (22) à chaque source de stockage d'énergie (13, 14) d'un modèle de comportement caractéristique ;
**caractérisé par** les étapes suivantes:
- détermination (24) des couples de sources de stockage d'énergie (13, 14) aptes à générer le profil de mission (16) avec une masse minimale ; et
- détermination (25), parmi les couples potentiels de sources de stockage d'énergie (13, 14), du couple (18) présentant la masse la plus faible.

2. Procédé selon la revendication 1, **caractérisé en ce que** chaque modèle de comportement caractéristique correspond à un diagramme de Ragone donnant l'énergie totale pouvant être fournie (Espec.bat, Espec.sc) par la source de stockage d'énergie (13, 14) selon la puissance fournie (Pspec.bat, Pspec.sc) rapportée par unité de masse de la source de stockage d'énergie (13, 14).

3. Procédé selon la revendication 2, caractérisé en que l'étape de détermination (24) des couples de sources de stockage d'énergie (13, 14) aptes à générer le profil de mission (16) avec une masse minimale comporte la sous-étape suivante, pour chaque couple de sources de stockage d'énergie (13, 14) candidates à l'hybridation, déterminer les points de fonctionnement du diagramme de Ragone des sources de stockage d'énergie (13, 14) aptes à générer le profil de mission (16) et à minimiser la masse totale des deux sources de stockage d'énergie (13, 14).

4. Procédé selon l'une des revendications 1 à 3, **caractérisé en ce qu'**il comporte une étape de comparaison (26) de la masse du couple (18) déterminé avec la masse d'une source d'énergie d'une architecture existante.

5. Procédé selon l'une des revendications 1 à 4, **caractérisé en ce qu'**il comporte les étapes suivantes :
- définition (23) des convertisseurs de puissance (38, 39) candidats à l'hybridation ;
- détermination (24) des couples de sources de stockage d'énergie (13, 14) aptes à générer le profil de mission (16) avec une masse minimale en fonction des convertisseurs de puissance (38, 39) disponibles ; et
- détermination (27) des convertisseurs de puissance (38, 39) en fonction du couple (18) déterminé.

6. Procédé selon l'une des revendications 1 à 5, **caractérisé en ce qu'**il comporte une étape d'affichage (28) des sources de stockage d'énergie (13, 14) du couple déterminé (18) et des profils d'utilisation (32, 33) en puissance des sources de stockage d'énergie (13, 14) du couple déterminé (18).

## Patentansprüche

1. Verfahren zur Optimierung einer Architektur (10) einer Stromversorgung einer Last (11), welches die folgenden Schritte umfasst:
- Bestimmung (20), durch mehrere Testreihen, eines die Bemessung bestimmenden Missionsprofils (16) in Abhängigkeit von der Leistung (Pchg(t)), die von der Last im Laufe der Zeit (t) benötigt wird;
- Definition (21) von verschiedenen Energiespeicherquellen (13, 14), die für die Hybridisierung in Frage kommen und aus Energiespeicherquellen (13, 14) vom Typ Batterie, Superkondensator oder Brennstoffzelle ausgewählt sind;
- Zuordnung (22), zu jeder Energiespeicherquelle (13, 14), eines charakteristischen Verhaltensmodells;
**gekennzeichnet durch** die folgenden Schritte:
- Bestimmung (24) der Paare von Energiespeicherquellen (13, 14), die geeignet sind, das Missionsprofil (16) mit einer minimalen Masse zu erzeugen; und
- Bestimmung (25), unter den potentiellen Paaren von Energiespeicherquellen (13, 14), des Paares (18), das die geringste Masse aufweist.

2. Verfahren nach Anspruch 1, **dadurch gekennzeichnet, dass** jedes charakteristische Verhaltensmodell einem Ragone-Diagramm entspricht, welches die Gesamtenergie, die von der Energiespeicherquelle (13, 14) geliefert werden kann (Espec.bat, Espec.sc), entsprechend der auf die Masseeinheit der Energiespeicherquelle (13, 14) bezogenen gelieferten Leistung (Pspec.bat, Pspec.sc) angibt.

3. Verfahren nach Anspruch 2, **dadurch gekennzeichnet, dass** der Schritt der Bestimmung (24) der Paare von Energiespeicherquellen (13, 14), die geeignet sind, das Missionsprofil (16) mit einer minimalen Masse zu erzeugen, den folgenden Teilschritt umfasst: Bestimmen, für jedes Paar von Energiespeicherquellen (13, 14), die für die Hybridisierung in Frage kommen, der Betriebspunkte des Ragone-Diagramms der Energiespeicherquellen (13, 14), die geeignet sind, das Missionsprofil (16) zu erzeugen und die Gesamtmasse der zwei Energiespeicherquellen (13, 14) zu minimieren.

4. Verfahren nach einem der Ansprüche 1 bis 3, **dadurch gekennzeichnet, dass** es einen Schritt des Vergleichs (26) der Masse des bestimmten Paares (18) mit der Masse einer Energiequelle einer existierenden Architektur umfasst.

5. Verfahren nach einem der Ansprüche 1 bis 4, **dadurch gekennzeichnet, dass** es die folgenden Schritte umfasst:
- Definition (23) der Leistungswandler (38, 39), die für die Hybridisierung in Frage kommen;
- Bestimmung (24) der Paare von Energiespeicherquellen (13, 14), die geeignet sind, das Missionsprofil (16) mit einer minimalen Masse zu erzeugen, in Abhängigkeit von den verfügbaren Leistungswandlern (38, 39); und
- Bestimmung (27) der Leistungswandler (38, 39) in Abhängigkeit von dem bestimmten Paar (18).

6. Verfahren nach einem der Ansprüche 1 bis 5, **dadurch gekennzeichnet, dass** es einen Schritt der Anzeige (28) der Energiespeicherquellen (13, 14) des bestimmten Paares (18) und der Leistungsnutzungsprofile (32, 33) der Energiespeicherquellen (13, 14) des bestimmten Paares (18) umfasst.

## Claims

1. Method for optimizing the architecture (10) of an electric power supply of a load (11), which comprises the following steps:
- determination (20), by a number of test series, of a dimensioning mission profile (16) according to the capacity demand (Pchg(t)) over time of the load (t);
- definition (21) of different energy storage sources (13, 14) that are candidates for hybridization, chosen among energy storage sources (13, 14) of the battery, super-capacitor or fuel cell type;
- association (22) of a characteristic behavior model with each energy storage source (13, 14);
**characterized by** the following steps:
- determination (24) of couples of energy storage sources (13, 14) which are capable of generating the mission profile (16) with minimum mass; and
- determination (25), among the potential couples of energy storage sources (13, 14), of the couple (18) with the lowest mass.

2. Method according to Claim 1, **characterized in that** each characteristic behavior model corresponds to a Ragone diagram giving the total energy which can be supplied (Espec.bat, Espec.sc) by the energy storage source (13, 14), according to the capacity delivered (Pspec.bat, Pspec.sc) per unit of mass of the energy storage source (13, 14).

3. Method according to Claim 2, **characterized in that** the step for determining (24) couples of energy storage sources (13, 14) which are capable of generating the mission profile (16) with minimum mass comprises the following sub-step: for each possible couple of energy storage sources (13, 14) for hybridization, determination of working points on the Ragone diagram for energy storage sources (13, 14) which are capable of generating the mission profile (16) and minimizing the total mass of the two energy storage sources (13, 14).

4. Method according to one of Claims 1 to 3, **characterized in that** it comprises a step for the comparison (26) of the mass of the couple (18) thus determined with the mass of an energy source in an existing architecture.

5. Method according to one of Claims 1 to 4, **characterized in that** it comprises the following steps:
- definition (23) of suitable power converters (38, 39) for hybridization;
- determination (24) of couples of energy storage sources (13, 14) which are capable of generating the mission profile (16) with minimum mass, as a function of available power converters (38, 39); and
- determination (27) of power converters (38, 39) as a function of the couple (18) thus determined.

6. Method according to one of Claims 1 to 5, **characterized in that** it comprises a step for the readout (28) of the energy storage sources (13, 14) in the couple (18) thus determined, and the capacity utilization profiles (32, 33) of the energy storage sources (13, 14) in the couple (18) thus determined.
